# EUROPEAN PATENT APPLICATION

(11) **EP 1 585 170 A2**
(43) Date of publication of application: **12.10.2005**
(21) Application number: 05006799.0
(22) Date of filing: 29.03.2005
(51) Int. Cl.: H01L 21/68, H01L 21/58, C09J 7/02

(54) **Dicing die bonding film**

(30) Priority: 01.04.2004 US 815420
(71) Applicant: National Starch and Chemical Investment Holding Corporation, Delaware 19720 (US)
(72) Inventor: Hwail, Jin, La Palma, California 90623 (US)
(74) Representative: Held, Stephan

(57) **Abstract**

A dicing die bonding adhesive film for disposition between a semiconductor silicon wafer and a dicing support tape comprises a Layer-1 adhesive, which comes in contact with the dicing tape, and a Layer-2 adhesive, which comes in contact with the silicon semiconductor wafer, in which the adhesion of Layer 2 to the silicon wafer is higher than the adhesion of Layer 1 to the dicing tape by at least 0.1N/cm.

## Description

### FIELD OF THE INVENTION

This invention relates to a multi-layer adhesive film comprising a combination of thermoplastic rubbers and thermoset resins, particularly for use as a dicing die bonding film within semiconductor packages.

### BACKGROUND OF THE INVENTION

One method of bonding a semiconductor die to a substrate uses a die bonding adhesive in the form of a film disposed between the die and the substrate. The adhesive film is applied to the semiconductor silicon wafer before it is sawed into individual chips or dies. To protect and support the silicon wafer during the dicing process, the adhesive film is contacted with a tape called a dicing tape. The adhesive film used for this construction is called a "dicing die bonding" film. Thus, the wafer, adhesive film, and dicing tape assembly is constructed prior to the dicing of the wafer.

The application of the adhesive film and dicing tape to the wafer is done in one construction method by first applying the adhesive film to the wafer and then applying the dicing tape to the adhesive film. In a second construction method, the adhesive film is first applied to the dicing tape, and then the combination of film and tape is applied to the wafer.

After the wafer is diced, the individual dies with adhesive attached are removed from the dicing tape and placed on a substrate for further fabrication processing. For removal of the die plus adhesive to occur, the adhesive should have higher adhesion to the silicon wafer than to the dicing tape. Currently available dicing die bonding films consist of a single layer of adhesive. In order to obtain release of the die with adhesive attached from the dicing tape, there must be an adequate difference between the adhesion of the adhesive to the silicon die and the adhesion of the adhesive to the dicing tape.

The dicing die bonding film is laminated to the semiconductor wafer at conditions ranging from ambient temperature to 50°C and 70,000 to 700,000 Pa pressure. Lamination temperatures higher than 50°C, which are often required to obtain adequate adhesion to the silicon with currently available materials, cause significant deformation of the wafer due to thermal stress. High temperatures can also cause the adhesive to bond too strongly to the dicing tape leading it to pull away from the silicon die when it is picked up for subsequent fabrication steps. However, when temperatures below 50°C are used, the result is often inadequate adhesion to the silicon die, causing the adhesive film to remain on the dicing tape when the die is picked up.

This invention is a solution to the above problem by providing a multi-layer film that provides distinct levels of adhesion to the silicon wafer and to the dicing tape at lamination temperatures that do not cause wafer deformation or that prevent release of the die and adhesive from the dicing tape.

### SUMMARY OF THE INVENTION

This invention is a dicing die bonding adhesive film for application to a semiconductor silicon wafer disposed between the semiconductor silicon wafer and a dicing support tape comprising (a) Layer-1 adhesive, which comes in contact with the dicing tape, and (b) Layer-2 adhesive, which comes in contact with the silicon semiconductor wafer, in which the adhesion of Layer 2 to the silicon wafer is higher than the adhesion of Layer 1 to the dicing tape by at least 0.1N/cm. In one embodiment, the Layer 1 adhesive has a characteristic peel strength to the dicing tape in the range of 0.05 to less than 0.5 N/cm, and the Layer 2 adhesive has a characteristic peel strength to the silicon wafer of 0.5 N/cm or higher, provided there is at least 0.1N/cm difference between the two adhesion values. The multi-layer film enables customization of adhesion to the materials encountered in the dicing die bonding process.

Suitable dicing tapes are polyolefin and poly(vinylchloride) films, such as those sold under the tradename Adwill® G-64 from Lintec corporation, or under the tradename Elepholder V-8-T, from Nitto Denko. Other suitable dicing tapes are those composed of polyester or polyimide. These tapes are commercially available and come in a format for use with UV radiation activation of the adhesive, or for use with pressure sensitive activation. In those cases in which a UV tape is used, the required characteristic peel strength of the adhesive to the UV tape will be in the range of 0.05 to less than 0.5N/cm after UV irradiation.

### DETAILED DESCRIPTION OF THE INVENTION

Layer-1 can be any adhesive composition that has characteristic peel strength to the dicing tape in the range of 0.05 to less than 0.5 N/cm and that can be laminated to Layer-2. Layer-2 can be any adhesive composition that has characteristic peel strength to the silicon wafer of 0.5 N/cm or higher and that can be laminated to Layer-1. It may be possible in some circumstances to be outside the above ranges provided there is always a difference in the peel strength of at least 0.1 N/cm.

Although any adhesives that meet the above peel strength and lamination criteria can be used, one suitable formulation for both Layer 1 and Layer 2 will contain (a) thermoplastic rubber, (b) thermoset resin, (c) hardener, (d) accelerator, and (e) filler, in which the thermoset resin for Layer 1 will have a softening point greater than 60°C, and the thermoset resin for Layer 2 will have a softening point below 60°C. Within this specification, the softening point of a material is defined as its melting point (Tm) or glass transition temperature (Tg). Typical weight percent ranges for this embodiment are 30-85 wt% thermoplastic rubber, 15-70 wt% thermoset resin, 0.05-40 weight % hardener, 0.01-10 weight % accelerator, and 1-80 weight % filler.

In a further embodiment of Layer-1, the thermoset resin will be a solid epoxy with a softening point of greater than 60°C and a weight per epoxy equivalent (WPE) of 100 to 1000. Suitable solid epoxies include bisphenol A, bisphenol F, phenol novolac, or cresol novolac, commercially available from Shell Chemicals and Dainippon Ink and Chemicals, Inc.

In a further embodiment of Layer-2, the thermoset resin will be an epoxy resin, such as, bisphenol A epoxy, bisphenol F epoxy, phenol novolac epoxy or cresol novolac epoxy and have a weight per epoxy equivalent (WPE) of 100 to 1000, and a softening point below 60°C. Such epoxies are commercially available from Shell Chemicals and Dainippon Ink and Chemicals, Inc.

In a further embodiment of Layer-2, a combination of thermoset resins may be used, and in that case, at least 20% of the total thermoset resins should have a softening point below 60°C. In addition to a combination of epoxies, other thermoset resins that are suitable for Layer-2 include maleimides, acrylates, vinyl ethers, and poly(butadienes) that have at least one double bond in a molecule.

Suitable maleimide resins include those having the generic structure 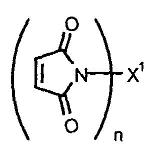 in which n is 1 to 3 and X¹ is an aliphatic or aromatic group. Exemplary X¹ entities include, poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. These types of resins are commercially available and can be obtained, for example, from National Starch and Chemical Company and Dainippon Ink and Chemical, Inc. In one embodiment, the maleimide resins are selected from the group consisting of 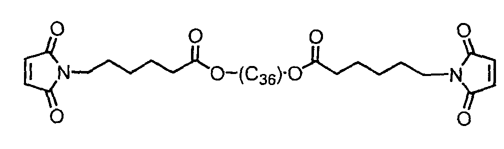 in which C₃₆ represents a linear or branched chain (with or without cyclic moieties) of 36 carbon atoms; 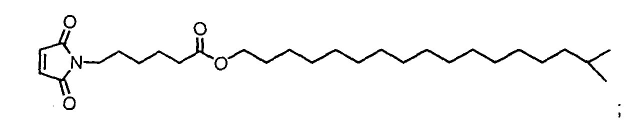 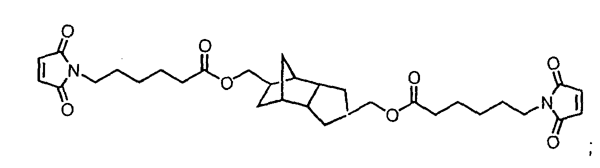 and

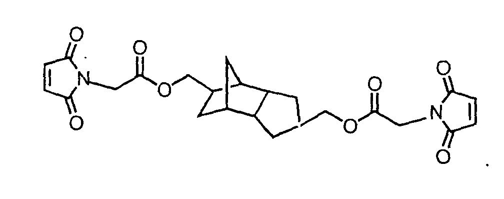

Suitable acrylate resins include those having the generic structure 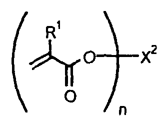 in which n is 1 to 6, R¹ is -H or -CH₃, and X² is an aromatic or aliphatic group. Exemplary X² entities include poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. Commercially available materials include butyl (meth)acrylate, isobutyl (meth)acrylate, 2-ethyl hexyl (meth)acrylate, isodecyl (meth)acrylate, n-lauryl (meth)acrylate, alkyl (meth)acrylate, tridecyl (meth)acrylate, n-stearyl (meth)acrylate, cyclohexyl(meth)acrylate, tetrahydrofurfuryl(meth)acrylate, 2-phenoxy ethyl(meth)acrylate, isobornyl(meth)acrylate, 1,4-butanediol di(meth)acrylate, 1.6 hexanediol di(meth)acrylate, 1,9-nonandiol di(meth)acrylate, perfluorooctylethyl (meth)acrylate, 1,10 decandiol di(meth)acrylate, nonylphenol polypropoxylate (meth)acrylate, and polypentoxylate tetrahydrofurfuryl acrylate, available from Kyoeisha Chemical Co., LTD; polybutadiene urethane dimethacrylate (CN302, NTX6513) and polybutadiene dimethacrylate (CN301, NTX6039, PRO6270) available from Sartomer Company, Inc; polycarbonate urethane diacrylate (ArtResin UN9200A) available from Negami Chemical Industries Co., LTD; acrylated aliphatic urethane oligomers (Ebecryl 230, 264, 265, 270,284, 4830, 4833, 4834, 4835, 4866, 4881, 4883, 8402, 8800-20R, 8803, 8804) available from Radcure Specialities, Inc; polyester acrylate oligomers (Ebecryl 657, 770, 810, 830, 1657, 1810, 1830) available from Radcure Specialities, Inc.; and epoxy acrylate resins (CN104, 111, 112, 115, 116, 117, 118, 119, 120, 124, 136) available from Sartomer Company, Inc. In one embodiment the acrylate resins are selected from the group consisting of isobornyl acrylate, isobornyl methacrylate, lauryl acrylate, lauryl methacrylate, poly(butadiene) with acrylate functionality and poly(butadiene) with methacrylate functionality.

Suitable vinyl ether resins include those having the generic structure 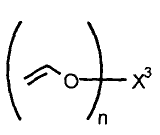 in which n is 1 to 6 and X³ is an aromatic or aliphatic group. Exemplary X³ entities include poly(butadienes), poly(carbonates), poly(urethanes), poly(ethers), poly(esters), simple hydrocarbons, and simple hydrocarbons containing functionalities such as carbonyl, carboxyl, amide, carbamate, urea, or ether. Commercially available resins include cyclohenanedimethanol divinylether, dodecylvinylether, cyclohexyl vinylether, 2-ethylhexyl vinylether, dipropyleneglycol divinylether, hexanediol divinylether, octadecylvinylether, and butandiol divinylether available from International Speciality Products (ISP); Vectomer 4010, 4020, 4030, 4040, 4051, 4210, 4220, 4230, 4060, 5015 available from Sigma-Aldrich, Inc.

Suitable poly(butadiene) resins include poly(butadienes), epoxidized poly(butadienes), maleic poly(butadienes), acrylated poly(butadienes), butadiene-styrene copolymers, and butadiene-acrylonitrile copolymers. Commercially available materials include homopolymer butadiene (Ricon130, 131, 134, 142, 150, 152, 153, 154, 156, 157, P30D) available from Sartomer Company, Inc; random copolymer of butadiene and styrene (Ricon 100, 181, 184) available from Sartomer Company Inc.; maleinized poly(butadiene) (Ricon 130MA8, 130MA13, 130MA20, 131MA5, 131MA10, 131MA17, 131MA20, 156MA17) available from Sartomer Company, Inc.; acrylated poly(butadienes) (CN302, NTX6513, GN301, NTX6039, PRO6270, Ricacryl 3100, Ricacryl 3500) available from Sartomer Inc.; epoxydized poly(butadienes) (Polybd 600, 605) available from Sartomer Company. Inc. and Epolead PB3600 available from Daicel Chemical Industries, Ltd; and acrylonitrile and butadiene copolymers (Hycar CTBN series, ATBN series, VTBN series and ETBN series) available from Hanse Chemical.

For either Layer-1 or Layer-2, the thermoplastic rubber will be present in an amount of 30-85 wt%; suitable thermoplastic rubbers include carboxy terminated butadiene-nitrile (CTBN)/epoxy adduct and nitrile butadiene rubber (NBR). The CTBN epoxy adduct consists of about 20-80 wt% CTBN and about 20-80 wt% diglycidyl ether bisphenol A : bisphenol A epoxy (DGEBA). CTBN will have a molecular weight in the range of about 100 to 1000 and DGEBA will have an equivalent weight (or weight per epoxy, g/epoxy) in the range of about 500 to 5000. The final adduct will have an equivalent weight of about 500 to 5000 g/epoxy and a melt viscosity at 150°C of 5000 to 100,000 cP. A variety of CTBN materials are available from Noveon Inc., and a variety of bisphenol A epoxy materials are available from Dainippon Ink and Chemicals, Inc., and Shell Chemicals. The NBR consists of acrylonitrile in the range of 20-50 wt% and butadiene in the range of 50-80 wt%, and has a glass transition temperature (Tg) from -40 to +20°C and a molecular weight (Mw) of 100,000 to 1,000,000. NBR rubbers of this type are commercially available from Zeon Corporation.

The hardener of Layer-1 or Layer-2 will be present in an amount of 0.5 to 40 wt%; suitable hardeners include phenolics, aromatic diamines, dicyandiamides, and polyamides. Suitable phenolics have an OH value of 90 to 110 and softening point of 60 to 110°C and are commercially available from Schenectady international, Inc. Suitable aromatic diamines are primary diamines and include diaminodiphenyl sulfone and diaminodiphenyl methane, commercially available from Sigma-Aldrich Co. Suitable dicyandiamides are available from SKW Chemicals, Inc. Suitable polyamides are commercially available from Air Products and Chemicals, Inc.

The accelerator of Layer-1 or Layer-2 will be present in an amount of 0.01 to 10 wt%; suitable accelerators include imidazoles or tertiary amines. Suitable imidazoles are commercially available from Air Products and Chemicals, Inc. Suitable tertiary amines are available from Sigma-Aldrich Co.

The filler of Layer-1 or Layer-2 will have a particle size of 0.1 to 10 µm and will be present in an amount of 1 to 80 wt%. Depending on the end application, the filler may be electrically or thermally conductive or nonconductive. Examples of suitable conductive fillers include silver, copper, gold, palladium, platinum, nickel, aluminum, and carbon black. Nonconductive fillers include alumina, aluminum hydroxide, silica, vermiculite, mica, wollastonite, calcium carbonate, titania, sand, glass, barium sulfate, and halogenated ethylene polymers such as, tetrafluorotheylene, trifluoroethylene, vinylidene fluoride, vinyl fluoride, vinylidene chloride, and vinyl chloride.

Other additives, such as adhesion promoters, in types and amounts known in the art, may also be added.

This film construction will perform within the commercially acceptable range for dicing die bonding films, having characteristic peel strength to the dicing tape in the range of 0.05 to less than 0.5 N/cm and characteristic peel strength to the wafer of 0.5 N/cm or higher. The film is capable of being laminated to the semiconductor wafer at the commercially acceptable conditions of 25 to 50°C temperature and 70,000 to 700,000 Pa pressure.

### EXAMPLES

In the following examples, four dicing die bonding films were prepared and compared for performance after adhesion to a silicon wafer. Examples 1 and 2 are inventive two-layer films and examples 3 and 4 are comparative single layer films. Example 5 sets out the performance results and testing method.

### EXAMPLE 1. FILM A.

Layer 1 (for adhesion to a dicing tape) was prepared by mixing the following components in parts by weight (pbw) in sufficient methyl ethyl ketone to make a paste:
60 pbw epoxy-modified CTBN (Mn: 15015, Tg: -17°C);
29 pbw cresol novolac epoxy (epoxy equivalent: 220, softening point: 90°C);
7 pbw 3,3'diaminodiphenyl sulfone,
1 pbw 2-phenyl 4-methyl imidazol
3 pbw silica filler (average size : 0.5 µm)
This paste was coated onto a 50 µm thick release-coated polyester film and dried at 90°C for 5 minutes to make Film A, Layer 1 at 10 µm thickness.

Layer 2 for adhesion to a silicon wafer was prepared by mixing the following components in parts by weight (pbw) in sufficient methyl ethyl ketone to make a paste:
60 pbw epoxy-modified CTBN (Mn: 15015, Tg: -17°C),
30 pbw bisphenol F epoxy( epoxy equivalent: 290, softening point: 4°C, viscosity: 35,000 mPaS at 50°C),
6 pbw 3,3'diaminodiphenyl sulfone,
1 pbw 2-phenyl 4-methyl imidazol
3 pbw silica filler (average size : 0.5 µm)
This paste was coated onto 50 µm thick release-coated polyester film and dried at 90°C for 5 minutes to make Film A, Layer 2 at 15 µm thickness.

The two layers were laminated to one another with a roll laminator at 80°C and 0.21 MPa and the laminated film was cut into a circle with a 220 mm diameter. The release liner of Layer 1 was peeled off and a dicing tape (Adwill® G-64, commercially available from Lintec Corporation) was laminated at room temperature and 0.21 MPa of pressure onto the surface of Layer 1.

### EXAMPLE 2. FILM B

Layer 1 (for adhesion to a dicing tape) was prepared by mixing the following components in parts by weight (pbw) in sufficient methyl ethyl ketone to make a paste:
60 pbw epoxy-modified CTBN (Mn: 15015, Tg: -17°C),
29 pbw cresol novolac epoxy (epoxy equivalent: 220, softening point: 90°C),
7 pbw 3,3'diaminodiphenyl sulfone,
1 pbw 2-phenyl 4-methyl imidazol
3 pbw silica filler (average size: 0.5µm)
This paste was coated onto 50µm thick release-coated polyester film and dried at 90°C for 5 minutes to make Layer 1 at 13 µm thickness.

Layer 2 for adhesion to a silicon wafer was prepared by mixing the following components in parts by weight (pbw) in sufficient methyl ethyl ketone to make a paste:
25 pbw carboxylated acrylonitrile butadiene copolymer rubber (Mw: 350,000, acrylonitrile content: 27 wt%, Tg: -20°C),
15 pbw vinyl terminated butadiene-nitrile rubber (acrylonitrile content : 21.5%, Tg: -45°C),
20 pbw 4,4'-bismaleimido-diphenyl-methane,
25 pbw adduct of tricyclodecane-dimethanol and 3-isopropenyldimethylbenzyl isocyanate,
5 pbw dicummyl peroxide
10 pbw silica filler (average size : 0.5µm)
This paste was coated on 50µm thick release-coated polyester film and dried at 90°C for 5 minutes to make Layer 2 at 12µm thickness.

The two layers were laminated to one another with a roll laminator at 80°C and 0.21 MPa and the laminated film was cut into a circle with a 220 mm diameter. The release liner of Layer 1 was peeled off and a dicing tape (Adwill® G-64) was laminated at room tempertaure and 0.21 MPa of pressure onto the surface of Layer 1.

### COMPARATIVE EXAMPLE 3. FILM C

Film C was prepared by mixing the following components in parts by weight (pbw) in sufficient methyl ethyl ketone to make a paste:
60 pbw epoxy-modified CTBN (Mn: 15015, Tg:-17°C),
29 pbw cresol novolac epoxy (epoxy equivalent: 220, softening point: 90°C),
7 pbw 3,3'diaminodiphenyl sulfone,
1 pbw 2-phenyl 4-methyl imidazol
3 pbw silica filler (average size : 0.5 µm)
This paste was coated onto 50µm thick release-coated polyester film and dried at 90°C for 5 minutes to make Film C at 25 µm thickness. The release liner of the film was peeled off and a dicing tape (Adwill® G-64) was laminated at room temperature and 0.21 MPa pressure onto its surface.

### COMPARATIVE EXAMPLE 4. FILM D

Film D was prepared by mixing the following components in parts by weight (pbw) in sufficient methyl ethyl ketone to make a paste:
25 pbw carboxylated acrylonitirle butadiene copolymer rubber (Mw: 350,000, acrylonitrile content: 27 wt%, Tg:-20°C),
15 pbw vinyl terminated butadiene-nitrile rubber (acrylonitrile content: 21.5%, Tg: -45°C)
20 pbw 4,4'-bismaleimido-diphenyl-methane,
25 pbw adduct of tricyclodecane-dimethanol and 3-isopropenyldimethylbenzyl isocyanate
5 pbw dicummyl peroxide
10 pbw silica filler (average size : 0.5µm)
This paste was coated on 50µm thick release-coated polyester film and dried at 90°C for 5 minutes to make Film D at 25 µm thickness. The release liner of the film was peeled off and a dicing tape (Adwill® G-64) was laminated at room temperature and 0.21 MPa pressure onto its surface.

### EXAMPLE 5. Performance and Test Method

Each of the Films A to D and a commercially available single layer adhesive tape (Film H) was laminated to a silicon wafer at various temperatures, irradiated with UV, and tested for 90° peel strength. The results of this testing are shown in Table 1.

**Table 1 -**

| Peel Strength at Various Lamination Temperatures (N/cm) | | | | | | |
|---|---|---|---|---|---|---|
| Lamin. Temp. (°C) | Substrate | Film A | Film B | Film C | Film D | Film H |
| 30 | Dicing Tape | 0.14 | 0.13 | 0.15 | 0.59 | |
| 30 | Silicon Wafer | 0.75 | 0.53 | 0.02 | 0.69 | |
| 40 | Dicing Tape | 0.15 | 0.15 | 0.16 | 0.65 | 0.10 |
| 40 | Silicon Wafer | 0.85 | 0.67 | 0.03 | 0.68 | 0.08 |
| 50 | Dicing Tape | 0.16 | 0.17 | 0.19 | 0.77 | 0.08 |
| 50 | Silicon Wafer | 0.83 | 0.74 | 0.05 | 0.67 | 0.13 |
| 60 | Dicing Tape | 0.18 | 0.19 | 0.18 | 0.8 | 0.07 |
| 60 | Silicon Wafer | 0.91 | 0.85 | 0.27 | 0.84 | 0.16 |
| 70 | Dicing Tape | 0.21 | 0.23 | 0.19 | 0.84 | 0.08 |
| 70 | Silicon Wafer | 0.95 | 0.83 | 0.52 | 0.96 | 0.35 |
| 80 | Dicing Tape | 0.25 | 0.26 | 0.23 | 0.97 | 0.06 |
| 80 | Silicon Wafer | 1.1 | 0.88 | 0.68 | 0.92 | 0.51 |
| 90 | Dicing Tape | 0.24 | 0.23 | 0.25 | 1.02 | |
| 90 | Silicon Wafer | 1.15 | 0.91 | 0.82 | 0.96 | |

Results indicate that both multi-layer Films A and B give acceptable peel strengths for good dicing and die pick up performance of between 0.05 and less than 0.5 N/cm with the dicing tape and between 0.5 and 10 N/cm with the silicon wafer, at all lamination temperatures tested. The comparative Film C had peel strength within the acceptable range against the dicing tape at all lamination temperatures; however, its adhesion to the silicon wafer was not acceptable at lamination temperatures below the commercially acceptable requirement of 50°C. The comparative Film D had peel strength within the acceptable range against the silicon wafer at all lamination temperatures; however, its adhesion to the dicing tape was too high at all conditions tested. The comparative commercial Film H had good adhesion to the dicing tape, but at temperatures below 50°C adhesion to the silicon wafer was inadequate.

Specimen were prepared for peel strength testing against the dicing tape by first removing the release liner from the dicing tape, and from the film to be tested. The two films were then laminated together at room temperature and 0.21 MPa pressure and cut into strips 10 mm wide. The release liner was removed from the remaining, exposed side of the film and the laminated structure (dicing tape plus film) was then laminated to a glass slide at the appropriate testing temperature, with the dicing tape on the top and the film against the glass. Peel was initiated manually.

Specimen were prepared for peel strength testing against the silicon wafer by first removing the release liner from the film to be tested and laminating it to the silicon wafer at the prescribed temperature to be tested. A pressure sensitive adhesive (PSA) that has a peel strength against the die attach film of more than 20 N/cm was then applied to the film at room temperature and 0.21 MPa pressure. A section of the film plus PSA 10 mm wide was then cut (while adhered to the wafer) and peeling of the sample was initiated manually.

Peel strength was tested at 90 degrees, with a 50 mm/min peel rate, at room temperature using an Imada SV-52N peel tester. Results were pooled and averaged.

## Claims

1. A dicing die bonding film for disposition between a semiconductor silicon wafer and a dicing support tape, the dicing die bonding film comprising
(a) Layer-1 adhesive, which comes in contact with the dicing support tape, and
(b) Layer-2 adhesive, which comes in contact with the semiconductor silicon wafer,
in which the adhesion of Layer-2 to the silicon wafer is higher than the adhesion of Layer-1 to the dicing tape by at least 0.1 N/cm.

2. The dicing die bonding film of claim 1 in which the Layer-1 adhesive has a characteristic peel strength to the dicing tape in the range of 0.05 to less than 0.5 N/cm, and the Layer-2 adhesive has a characteristic peel strength to the semiconductor silicon wafer of 0.5 N/cm or higher.

3. The dicing die bonding film of claim 1 in which the Layer-1 adhesive comprises (a) thermoplastic rubber, (b) thermoset resin having a softening point above 60°C, (c) hardener, (d) accelerator, and (e) filler; and in which the Layer-2 adhesive comprises (a) thermoplastic rubber, (b) thermoset resin in which at least 20% of the thermoset resin has a softening point below 60°C, (c) hardener, (d) accelerator, and (e) filler.

4. The dicing die bonding film of claim 3 in which the Layer-1 adhesive comprises (a) 30-85 weight % thermoplastic rubber, (b) 15-70 weight % thermoset resin having a softening point above 60°C, (c) 0.05-40 weight % hardener, (d) 0.01-10 weight % accelerator, and (e) 1-80 weight % filler and the Layer-2 adhesive comprises (a) 30-85 weight % thermoplastic rubber, (b) 15-70 weight % thermoset resin, in which at least 20% of the thermoset resin has a softening point below 60°C, (c) 0.05-40 weight % hardener, (d) 0.01-10 weight % accelerator, and (e) 1-80 weight % filler.

5. The dicing die bonding film of claim 1 in which the thermoset resin in Layer-1 is a solid epoxy with a softening point of greater than 60°C and a weight per epoxy equivalent of 100 to 1000.

6. The dicing die bonding film of claim 1 in which the thermoset resin in Layer-2 is an epoxy having a softening point below 60°C and a weight per epoxy equivalent of 100 to 1000.

7. The dicing die bonding film of claim 1 in which the thermoset resin in Layer-2 is a mixture of thermoset resins and at least 20% of the total Layer-2 thermoset resins have a softening point below 60°C.

8. The dicing die bonding film of claim 1 in which the thermoplastic rubber is carboxy terminated butadiene-nitrile/epoxy adduct and nitrile butadiene rubber.

9. The dicing die bonding film of claim 8 in which the carboxy terminated butadiene-nitrile/epoxy adduct consists of about 20-80 wt% carboxy terminated butadiene-nitrile and about 20-80 wt% diglycidyl ether bisphenol A : bisphenol A epoxy.
